# EUROPEAN PATENT APPLICATION

(11) **EP 4 583 165 A1**
(43) Date of publication of application: **09.07.2025**
(21) Application number: 24150448.9
(22) Date of filing: 04.01.2024
(51) Int. Cl.: H01L 29/06, H01L 29/739, H01L 29/861, H01L 29/40

(54) **REVERSE CONDUCTING INSULATED-GATE BIPOLAR TRANSISTOR AND METHOD OF MANUFACTURING**

(71) Applicant: Nio Technology (Anhui) Co., Ltd, Hefei City, Anhui 230601 (CN)
(72) Inventor: LONG, Hongyao, Oxford (GB); NGWENDSON, Luther-King, Oxford (GB); SURESH, Vinay, Oxford (GB); LI, Daohui, Oxford (GB)
(74) Representative: Vossius & Partner Patentanwälte Rechtsanwälte mbB

(57) **Abstract**

The present disclosure relates to a reverse conducting insulated-gate bipolar transistor (10), including a main substrate (12), a plurality of insulated-gate bipolar transistor regions (14) provided on the main substrate (12), and a plurality of diode regions (16) provided on the main substrate (12). The insulated-gate bipolar transistor regions (14) and/or the diode regions (16) are arranged in a plurality of rows (18, 19, 20), each row (18, 19, 20) extending in a first direction (d1). Along a second direction (d2) which is substantially perpendicular to the first direction (d1), the insulated-gate bipolar transistor regions (14) of at least two adjacent rows of the plurality of rows (18, 19, 20) and/or the diode regions (16) of at least two adjacent rows of the plurality of rows (18, 19, 20) are arranged in a staggered manner.

The present disclosure also relates to a method of manufacturing at least one reverse conducting insulated-gate bipolar transistor (10).

## Description

Power semiconductor devices are widely used in a variety of fields and/or for a number of purposes. In particular, power semiconductor devices may be used as switches or rectifiers in power electronic, e.g., in a switched-mode power supply.

An insulated-gate bipolar transistor (IGBT) is a type of power semiconductor device which is used primarily to provide and/or form an electronic switch. Insulated-gate bipolar transistors are generally considered to combine relatively high efficiency with relatively fast switching.

Insulated-gate bipolar transistors often block reverse current flow. This means that, e.g., unlike a metal-oxide-semiconductor field-effect transistor (MOSFET), insulated-gate bipolar transistors generally cannot conduct current flow in a reverse direction. Hence, insulated-gate bipolar transistors have been modified, where reverse current flow is needed and/or expedient, by including at least one additional diode, sometimes referred to as a freewheeling diode ("FWD"), on the same chip as the insulated-gate bipolar transistor. The additional diode(s) may be arranged in parallel, in particular anti-parallel, with the respective insulated-gate bipolar transistor(s) to conduct, preferably selectively, current in the opposite or reverse direction. Such a reverse conduction insulated-gate bipolar transistor may replace a combination of one or more insulated-gate bipolar transistors chips and one or more separate diode chips, also referred to as a "separate IGBT and diode solution", which may provide a more compact size.

However, the insulated-gate bipolar transistors known from the prior art have several drawbacks. For instance, insulated-gate bipolar transistors in general generate a relatively large amount of heat. This may make the insulated-gate bipolar transistors known from the prior art vulnerable to damage and/or may reduce the lifetime of the insulated-gate bipolar tra nsistors.

Reverse conduction insulated-gate bipolar transistors are known to dissipate heat relatively well, in particular relative to insulated-gate bipolar transistors without a reverse conduction function, due to the alternating operation of the various regions of the reverse conduction insulated-gate bipolar transistors, in particular as an IGBT and as a freewheeling diode in an alternating manner. However, there remains a need to further increase and/or improve the ability of reverse conduction insulated-gate bipolar transistors to cope with the generated heat.

For instance, as chips, e.g., reverse conduction insulated-gate bipolar transistors, become more compact over the years, the issue of heat generation by the respective transistors may be exacerbated.

Moreover, as a further example, as chips become more powerful, they may generate more heat, in particular in relation to their size, further increasing the need for an improvement in coping with the generated heat.

Furthermore, improving a device's, e.g., a reverse conduction insulated-gate bipolar transistor's, ability to cope with heat generated by the device is advantageous in general, e.g., to improve the device's lifetime and/or reduce the risk of damage and/or failure.

However, the above-identified aspects have not, or at least not sufficiently, been addressed in the prior art. Thus, there is a need to improve the reverse conduction insulated-gate bipolar transistors known from the prior art.

It is therefore an object of the present invention to provide an improved insulated-gate bipolar transistor, in particular by providing improvement to one or more of the above-identified aspects.

The above-identified object is achieved by a reverse conducting insulated-gate bipolar transistor, as defined by the features of claim 1. Preferred embodiments are defined by the features of the dependent claims, respectively.

The transistor may include a main substrate. The transistor may include a plurality of insulated-gate bipolar transistor regions, also referred to as IGBT region, which may be provided on and/or in the main substrate. The transistor may include a plurality of diode regions provided on and/or in the main substrate. The insulated-gate bipolar transistor regions and/or the diode regions may be arranged in a plurality of rows, each row extending in a first direction. The main substrate may be made of at least one semiconductor material. The main substrate may include one or more layers, preferably a plurality of layers which may be made of (or may include) different materials and/or may be treated differently to provide one or more different properties.

Such a configuration of a reverse conducting insulated-gate bipolar transistor having a plurality of insulated-gate bipolar transistor (IGBT) regions and a plurality of diode regions arranged in rows is known from the prior art, as discussed above. Such a reverse conducting insulated-gate bipolar transistor may enable current flow in two directions, in particular two substantially opposites directions, by operating the insulated-gate bipolar transistor (IGBT) regions and the diode regions in an alternating manner, preferably sequentially and/or selectively.

According to the present disclosure, however, along a second direction which is substantially perpendicular to the first direction, the insulated-gate bipolar transistor regions of at least two adjacent rows, preferably at least three adjacent rows, of the plurality of rows and/or the diode regions of at least two adjacent rows, preferably at least three adjacent rows, of the plurality of rows may be arranged in a staggered manner. In other words, the insulated-gate bipolar transistor regions of at least two adjacent rows, preferably at least three adjacent rows, of the plurality of rows and/or the diode regions of at least two adjacent rows, preferably at least three adjacent rows, of the plurality of rows are arranged offset from each other, i.e., in a checkered pattern. In other words, the insulated-gate bipolar transistor regions of at least two adjacent rows, preferably at least three adjacent rows, of the plurality of rows and/or the diode regions of at least two adjacent rows, preferably at least three adjacent rows, of the plurality of rows are not aligned, i.e., at least partially misaligned. In other words, the insulated-gate bipolar transistor regions of at least two adjacent rows, preferably at least three adjacent rows, of the plurality of rows and/or the diode regions of at least two adjacent rows, preferably at least three adjacent rows, of the plurality of rows do not overlap, or at least do not completely overlap, along the second direction.

This may increase a boundary area and/or boundary volume which borders the insulated-gate bipolar transistor regions and/or the diode regions to which heat generated by the respective regions, in particular when the respective regions are being operated, can be dissipated. This may increase a level of heat dissipation from the insulated-gate bipolar transistor regions and/or the diode regions. In particular, this may allow the insulated-gate bipolar transistor regions and/or the diode regions to dissipate heat to one or more adjacent row(s), or at least improve such heat dissipation. This may improve a temperature distribution of the reverse conducting insulated-gate bipolar transistor, e.g., at one or more surfaces thereof.

Moreover, arranging the insulated-gate bipolar transistor regions of at least two adjacent rows, preferably at least three adjacent rows, of the plurality of rows and/or the diode regions of at least two adjacent rows, preferably at least three adjacent rows, of the plurality of rows in a staggered manner along the second direction may reduce a size of each insulated-gate bipolar transistor region and/or each diode region and/or may increase a surface to volume ratio of each region, which may increase and/or facilitate heat dissipation from the respective region, e.g., compared with a configuration in which the insulated-gate bipolar transistor regions and/or the diode regions are arranged in lines or stripes.

Preferably, the diode regions and/or the insulated-gate bipolar transistor regions are arranged such that the diode regions and/or the insulated-gate bipolar transistor regions can dissipate heat in at least 3, preferably at least 4, directions which substantially lie in a single plane, e.g., at least along each row in the first direction and a direction opposite to the first direction, and to adjacent rows in the second direction and a direction opposite to the second direction.

Preferably, at least some of the insulated-gate bipolar transistor regions, preferably each insulated-gate bipolar transistor region, is/are arranged adjacent to at least three, preferably at least four, diode regions. Alternatively, or additionally, at least some of the diode regions, preferably each diode region, is/are arranged adjacent to at least three, preferably at least four, insulated-gate bipolar transistor regions. Preferably, adjacent insulated-gate bipolar transistor regions along the first direction and/or second direction are separated from each other by at least one diode region. The respective insulated-gate bipolar transistor regions and/or diode regions may dissipate heat to the adjacent other of insulated-gate bipolar transistor regions and diode regions.

Preferably, in addition, the insulated-gate bipolar transistor regions of at least two adjacent rows of the plurality of rows and/or the diode regions of at least two adjacent rows of the plurality of rows are arranged in a staggered manner along the first direction. In other words, the insulated-gate bipolar transistor regions of at least two adjacent rows, preferably at least three adjacent rows, of the plurality of rows and/or the diode regions of at least two adjacent rows, preferably at least three adjacent rows, of the plurality of rows are arranged in a staggered manner along the first direction and the second direction. This may further increase a boundary area and/or boundary volume which borders the insulated-gate bipolar transistor regions and/or the diode regions to which heat generated by the respective regions, in particular when the respective regions are being operated, can be dissipated.

The term "row", within the context of the present disclosure, can mean a row and/or a column.

The reverse conducting insulated-gate bipolar transistor may be configured such that the plurality of insulated-gate bipolar transistor (IGBT) regions are operable, e.g., in an IGBT mode, simultaneously. Alternatively, or additionally, the reverse conducting insulated-gate bipolar transistor may be configured sch that the plurality of diode regions are operable, e.g., in a reverse or free-wheeling mode, simultaneously

The diode regions may be configured as freewheeling diodes (FWD) or fast recovery diodes (FRD).

Each insulated-gate bipolar transistor region may include one or more trenches which may be filled with an electrode material, e.g., polysilicon. In other words, the insulated-gate bipolar transistor regions may be configured as trench-gate-type insulated-gate bipolar transistor regions. Preferably, at least one of the trenches substantially encloses, at least circumferentially, the respective insulated-gate bipolar transistor region, or at least one or more components of the respective insulated-gate bipolar transistor region. At least one gate, preferably at least one insulated gate, may be provided or formed on and/or in one or more trenches. The insulated gate may include at least one electrically conductive material, which may also be referred to as a gate electrode, which may be at least partially filled in the respective trench(es). The gate(s) may be at least partially electrically insulated by at least one gate insulator film which may at least partially cover or coat the conductive material. The gate or gate electrode may be electrically connected or connectable to a gate electrode terminal.

Each insulated-gate bipolar transistor region may be divided into a plurality of sub-regions by the trenches. Each trench of the insulated-gate bipolar transistor regions may extend from a front surface side of the main substrate into a layer of the main substrate, the layer preferably made of an n type, or n-base, semiconductor material. Each trench may end in said layer.

Each diode region may include one or more trenches which may be filled with an electrode material, e.g., polysilicon. Preferably, at least one of the trenches substantially encloses, at least circumferentially, the respective diode region. At least one electrically conductive material may be at least partially filled in the respective trench(es). The conductive material may be at least partially electrically insulated by at least one gate insulator film which may at least partially cover or coat the conductive material.

Each diode region may be divided into a plurality of sub-regions by one or more of the trenches. Each trench of the diode regions may extend from a front surface side of the main substrate into a layer of the substrate, the layer preferably being made of an n type, or n base, semiconductor material. Each trench may end in said layer.

The trenches in the diode regions may be connected to an emitter potential, e.g., by one or more contacts, e.g., to at least one top metal layer. The trenches in the diode regions may not be configured to conduct current.

The trenches in the insulated-gate bipolar transistor regions may be used for current conduction and may also be referred to as gate trenches.

The insulated-gate bipolar transistor regions and the diode regions may be arranged in an alternating manner along the first direction and/or the second direction.

The transistor may include a plurality of rows of the insulated-gate bipolar transistor regions and/or a plurality of rows of the diode regions along the first direction and/or the second direction.

The insulated-gate bipolar transistor regions and the diode regions may be separated from each other by at least one isolating region configured to substantially isolate at least one of the insulated-gate bipolar transistor regions from at least one of the diode regions.

Each isolating region may include at least one isolation trench, preferably a plurality of isolation trenches. Each isolating region may include at least one p type, preferably at least deep diffused p type, region. The p type region may extend further into the main substrate, e.g., into at least one underlying layer, preferably made of an n type, or n base, semiconductor material, than one or more of the trenches of the insulated-gate bipolar transistor regions and/or the diode regions, preferably than each trench. At least one of the trenches may at least partially enclose, preferably completely enclosed about at least one circumference, each diode region and/oreach insulated-gate bipolar transistor region, or at least some of the diode regions and/or at least some of the insulated-gate bipolar transistor regions.

The p type region may extend into the underlying n type layer, also referred to as injunction depth, by at least 1.5 µm.

A "p type region", within the context of the present disclosure, is to be understood as a region, preferably an implanted region, with boron and/or indium, preferably high energy boron species and/or indium species, preferably doped with boron and/or indium. The p type region has preferably received thermal treatment.

In case the p type region is configured as a deep diffused p type region, the p type region may extend into the underlying n type layer, also referred to as injunction depth, by at least of at least 4 µm.

An "n type region", within the context of the present disclosure, is to be understood as a region, preferably an implanted region, with phosphorus, arsenic and/or antimony, preferably doped with phosphorus, arsenic and/or antimony.

Each Isolation trench, or at least some of the isolation trenches, may be connected to an emitter potential.

The p type region may be arranged at least partially between at least two of the plurality of isolation trenches of the respective isolating region.

Each insulated-gate bipolar transistor region may include at least one collector layer, which is preferably made of a p type, preferably a p+ type, semiconductor material, preferably having a high impurity concentration. The collector layer may be arranged on an opposite side of an n type layer, at least partially within the main substrate, than the trenches of the insulated-gate bipolar transistor region and/or the diode regions.

Each insulated-gate bipolar transistor region may include at least one cathode layer, which is preferably made of an n type semiconductor material, preferably having a high impurity concentration.

The main substrate may include at least one buffer layer, which is preferably made of an n type semiconductor material. The buffer layer may be arranged at least partially between the cathode layer and the trench(es) of the insulated-gate bipolar transistor regions and/or the diode regions and/or between the collector layer and the trench(es) of the insulated-gate bipolar transistor regions and/or the diode regions. Preferably, at least two layers, preferably both made of an n type semiconductor material, may be arranged at least partially between the cathode layer and the trench(es) of the insulated-gate bipolar transistor regions and/or the diode regions and/or between the collector layer and the trench(es) of the insulated-gate bipolar transistor regions and/or the diode regions.

Each insulated-gate bipolar transistor region and/or each diode region may have an aspect ratio of a length along the first direction to a length along the second direction in a range of 0.4 to 2.5, preferably 0.5 to 2.4, more preferably 0.6 to 2.2, more preferably 0.6 to 2, more preferably 0.6 to 1.8, more preferably 0.6 to 1.6, more preferably 0.6 to 1.4, more preferably 0.8 to 1.4, more preferably 0.8 to 1.2. This may increase and/or facilitate heat dissipation from the respective region, e.g., compared with regions which are configured as stripes or lines which have greater aspect ratios.

The transistor may further include at least one gate signal distributor trench which interconnects one or more trenches of adjacent insulated-gate bipolar transistor regions. The gate signal distributor trench may be configured to supply each insulated-gate bipolar transistor region with a gate voltage, in particular an applied gate voltage. The gate signal distributor, or at last one or more sections thereof, may extend in the first direction or the second direction, i.e., along a substantially straight path and/or a staggered path. The gate signal distributor trench may extend at least partially into the substrate and may be configured to at least partially receive an electrically conductive material.

One or more of the insulated-gate bipolar transistor regions may include at least one first trench which extends circumferentially around one or more second trenches of the respective insulated-gate bipolar transistor region.

Each insulated-gate bipolar transistor region, or at least some of the insulated-gate bipolar transistor regions, may include at least one first trench, preferably a plurality of first trenches. Each first trench may be configured as a dummy gate or dummy trench. The dummy gate or dummy trench may also be referred to as an auxiliary trench or auxiliary gate, or more generally as a "dummy region". Each insulated-gate bipolar transistor region, or at least some of the insulated-gate bipolar transistor regions, may include at least one second trench, preferably a plurality of second trenches. Each second trench may be configured as a true gate.

A dummy region, within the context of the present disclosure, is to be understood as a region, e.g., a dummy trench or a dummy gate, which is not used for current conduction in an on-state of the respective region, i.e., of the respective insulated-gate bipolar transistor region and/or diode region.

The dummy region(s), e.g., a dummy trench or a dummy gate, may be configured as a p type region.

The dummy region(s) may be electrically connected or connectable to at least one top layer of metal, e.g., an emitter or emitter potential. Alternatively, the dummy gate(s) or dummy trench(es) may be "floating", i.e., not connected to any potential.

Each insulated-gate bipolar transistor region, or at least some of the insulated-gate bipolar transistor regions, may include at least one p type region, preferably at least one deep p type region.

Each insulated-gate bipolar transistor region, or at least some of the insulated-gate bipolar transistor regions, may include a plurality of trenches and/or each diode region includes a plurality of trenches.

At least two adjacent trenches of the plurality of trenches in one or more of the insulated-gate bipolar transistor regions may be arranged at a distance of at least 1 µm , preferably at least 2 µm, more preferably at least 3 µm, more preferably at least 4 µm, more preferably at least 5 µm.

At least two adjacent trenches of the plurality of trenches in one or more of the insulated-gate bipolar transistor regions may be arranged at a distance of less than 1 µm, preferably less than 0.9 µm, more preferably less than 0.8 µm, more preferably less than 0.7 µm, more preferably less than 0.6 µm, more preferably less than 0.5 µm.

The present disclosure also relates to a method of manufacturing at least one reverse conducting insulated-gate bipolar transistor, preferably the reverse conducting insulated-gate bipolar transistor according to any of the preceding claims. The features, configurations, and advantages, as described above with respect to the reverse conducting insulated-gate bipolar transistor, applies to the method accordingly.

The method may include:
providing a main substrate.

The method may include:
providing a plurality of insulated-gate bipolar transistor regions and a plurality of diode regions on the main substrate such that the insulated-gate bipolar transistor regions and/or the diode regions are arranged in a plurality of rows, each row extending in a first direction. Along a second direction which is substantially perpendicular to the first direction, the insulated-gate bipolar transistor regions of at least two adjacent rows of the plurality of rows and/or the diode regions of at least two adjacent rows of the plurality of rows may be arranged in a staggered manner.

Various exemplary embodiments of the present disclosure disclosed herein are directed to providing features that will become readily apparent by reference to the following description when taken in conjunction with the accompanying drawings. In accordance with various embodiments, exemplary devices are disclosed herein. It is understood, however, that these embodiments are presented by way of example and not limitation, and it will be apparent to those of ordinary skill in the art who read the present disclosure that various modifications to the disclosed embodiments can be made while remaining within the scope of the present disclosure.

Thus, the present disclosure is not limited to the exemplary embodiments and applications described and illustrated herein. Additionally, the specific order and/or hierarchy of steps in the methods disclosed herein are merely exemplary approaches. Based upon design preferences, the specific order or hierarchy of steps of the disclosed methods or processes can be re-arranged while remaining within the scope of the present disclosure. Thus, those of ordinary skill in the art will understand that the methods and techniques disclosed herein present various steps or acts in a sample order, and the present disclosure is not limited to the specific order or hierarchy presented unless expressly stated otherwise.

The following list of aspects provides alternative and/or further features of the invention:
1. A transistor, preferably configured as a reverse conducting insulated-gate bipolar, the transistor including:
   a main substrate;
   a plurality of first selectively electrically conductive regions, preferably a plurality of insulated-gate bipolar transistor regions, provided on and/or in the main substrate;
   a plurality of second selectively electrically conductive regions, preferably a plurality of diode regions, provided on and/or in the main substrate;
   wherein the first selectively conductive regions and/or the second selectively conductive regions are arranged in a plurality of rows, each row extending in a first direction, and
   wherein, along a second direction which is substantially perpendicular to the first direction, the first selectively conductive regions of at least two adjacent rows of the plurality of rows and/or the second selectively conductive regions of at least two adjacent rows of the plurality of rows are arranged in a staggered manner.
2. The transistor according to aspect 1, wherein the insulated-gate bipolar transistor regions and the diode regions are arranged in an alternating manner along the first direction and/or the second direction.
3. The transistor according to aspect 1 or 2, wherein the transistor includes a plurality of rows of the insulated-gate bipolar transistor regions and/or a plurality of rows of the diode regions along the second direction.
4. The transistor according to any of the preceding aspects, wherein the insulated-gate bipolar transistor regions and the diode regions are separated from each other by at least one isolating region configured to substantially isolate at least one of the insulated-gate bipolar transistor regions from at least one of the diode regions.
5. The transistor according to aspect 4, wherein each isolating region includes at least one isolation trench, preferably a plurality of isolation trenches, and optionally at least one deep diffused p type region.
6. The transistor according to aspect 5, wherein the deep diffused p type region is arranged at least partially between at least two of the plurality of isolation trenches of the respective isolating region.
7. The transistor according to any of the preceding aspects, wherein each insulated-gate bipolar transistor region and/or each diode region has/have an aspect ratio of a length along the first direction to a length along the second direction in a range of 0.4 to 2.5, preferably 0.5 to 2.4, more preferably 0.6 to 2.2, more preferably 0.6 to 2.
8. The transistor according to any of the preceding aspects, further including at least one gate signal distributor trench which interconnects one or more trenches of adjacent insulated-gate bipolar transistor regions.
9. The transistor according to any of the preceding aspects, wherein one or more of the insulated-gate bipolar transistor regions include at least one first trench which extends circumferentially around one or more second trenches of the respective insulated-gate bipolar transistor region.
10. The transistor according to any of the preceding aspects, wherein each insulated-gate bipolar transistor region includes at least one first trench, preferably a plurality of first trenches, each first trench being configured as a dummy gate, and at least one second trench, preferably a plurality of second trenches, each second trench being configured as a true gate.
11. The transistor according to any of the preceding aspects, wherein each insulated-gate bipolar transistor region includes at least one deep p type region.
12. The transistor according to any of the preceding aspects, wherein each insulated-gate bipolar transistor region includes a plurality of trenches and/or each diode region includes a plurality of trenches.
13. The transistor according to aspect 12, wherein at least two adjacent trenches of the plurality of trenches in one or more of the insulated-gate bipolar transistor regions are arranged at a distance of at least 1 µm, preferably at least 2 µm, more preferably at least 3 µm, more preferably at least 4 µm, more preferably at least 5 µm.
14. The transistor according to aspect 12 or 13, wherein at least two adjacent trenches of the plurality of trenches in one or more of the insulated-gate bipolar transistor regions are arranged at a distance of less than 1 µm, preferably less than 0.9 µm, more preferably less than 0.8 µm, more preferably less than 0.7 µm, more preferably less than 0.6 µm, more preferably less than 0.5 µm.
15. The transistor according to any of the preceding aspects, wherein the first selectively conductive regions and the second selectively conductive regions are operable in an alternating manner and/or in a non-overlapping manner, such that the first selectively conductive regions may be operated before and/or after operating the the second selectively conductive regions.
16. Method of manufacturing at least one transistor, preferably at least one reverse conducting insulated-gate bipolar transistor, preferably the reverse conducting insulated-gate bipolar transistor according to any of the preceding aspects, including:
   - providing a main substrate;
   - providing a plurality of first selectively electrically conductive regions, preferably a plurality of insulated-gate bipolar transistor regions, and a plurality of second selectively electrically conductive regions, preferably a plurality of diode regions, on and/or in the main substrate such that the first selectively electrically conductive regions and/or the second selectively electrically conductive regions are arranged in a plurality of rows, each row extending in a first direction, wherein, along a second direction which is substantially perpendicular to the first direction, the first selectively electrically conductive regions of at least two adjacent rows of the plurality of rows and/or the second selectively electrically conductive regions of at least two adjacent rows of the plurality of rows are arranged in a staggered manner.

Embodiments of the present invention are further elucidated below with reference to the figures. The figures are schematic drawings and as such may not show all details of the systems and their components. Particularly, the drawings are not necessarily to scale and the shown dimensions are only exemplary and may vary. The drawings illustrate exemplary embodiments to provide a thorough understanding of the present invention. The drawings are not intended to limit the scope of the invention, which is defined by the appended claims and is to include the equivalents thereof.
- Fig. 1a: shows, in a schematic top view, a reverse conducting insulated-gate bipolar transistor according to an embodiment of the present disclosure;
- Fig. 1b: shows, in a schematic top view, a reverse conducting insulated-gate bipolar transistor according to an embodiment of the present disclosure;
- Fig. 1c: shows, in a schematic top view, a reverse conducting insulated-gate bipolar transistor according to an embodiment of the present disclosure;
- Fig. 2: shows, in a schematic top view, the reverse conducting insulated-gate bipolar transistor of Fig. 1a;
- Fig. 3: shows, in a schematic bottom view, the reverse conducting insulated-gate bipolar transistor of Figs. 1a and 2;
- Fig. 4: shows, in a schematic top view, a reverse conducting insulated-gate bipolar transistor according to an embodiment of the present disclosure;
- Fig. 5: shows, in a schematic top view, a path of a gate signal distributor trench of the reverse conducting insulated-gate bipolar transistor of Fig. 4;
- Fig. 6: shows, in a schematic top view, a path of a gate signal distributor trench of the reverse conducting insulated-gate bipolar transistor of Fig. 4;
- Fig. 7: shows, in a schematic and enlarged cross-sectional view, details of an insulatedgate bipolar transistor region and a diode region of the reverse conducting insulated-gate bipolar transistor of Figs. 1a to 6;
- Fig. 8: shows, in a schematic and enlarged cross-sectional view, a modified insulated-gate bipolar transistor region according to an embodiment of the present disclosure;
- Fig. 9: shows, in a schematic and enlarged cross-sectional view, a modified insulated-gate bipolar transistor region according to an embodiment of the present disclosure.

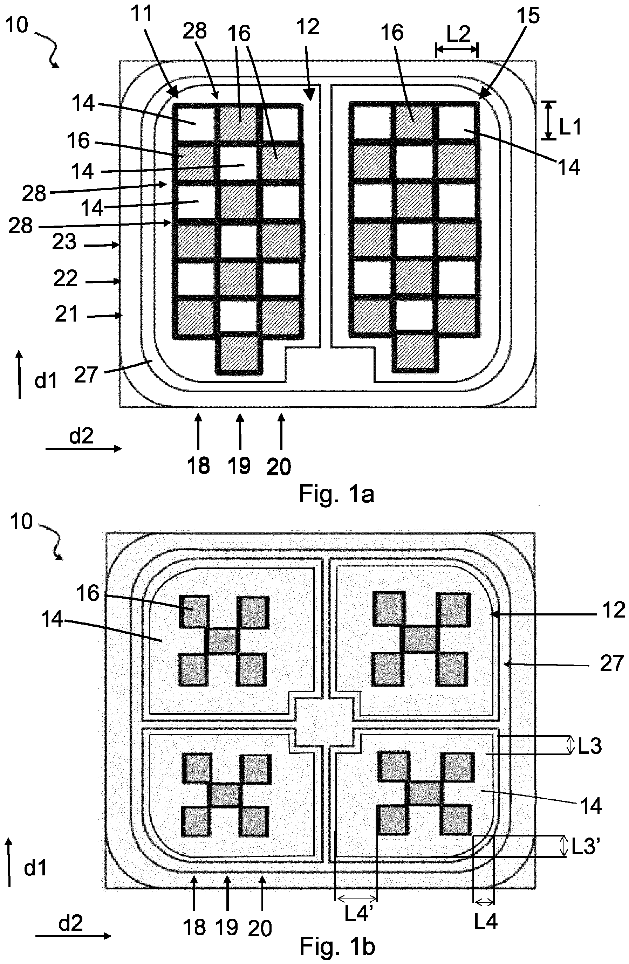

Figs. 1a to 1c show, in schematic top views, a reverse conducting insulated-gate bipolar transistor 10. The transistor 10 may include a main substrate 12 and a plurality of insulated-gate bipolar transistor regions 14 provided on and/or in the main substrate 12. In The transistor 10 may include a plurality of diode regions 16 provided on and/or in the main substrate 12. For the sake of clarity, only some of the insulated-gate bipolar transistor regions 14 and the diode regions 16 in the Figures have been provided with references signs. The same may apply to one or more further components shown in the Figures.

The transistor 10 may include at least two transistor segments 11 and 15, as shown in exemplary manner in Fig. 1a. Each transistor segment 11, 15 may include a plurality of insulated-gate bipolar transistor regions 14 and a plurality of diode regions 16. The transistor segments 11 and 15 may be configured substantially identically. Alternatively, the transistor segments 11 and 15 may be configured differently, e.g., with a different number and/or arrangement of the insulated-gate bipolar transistor regions 14 and/or diode regions 16.

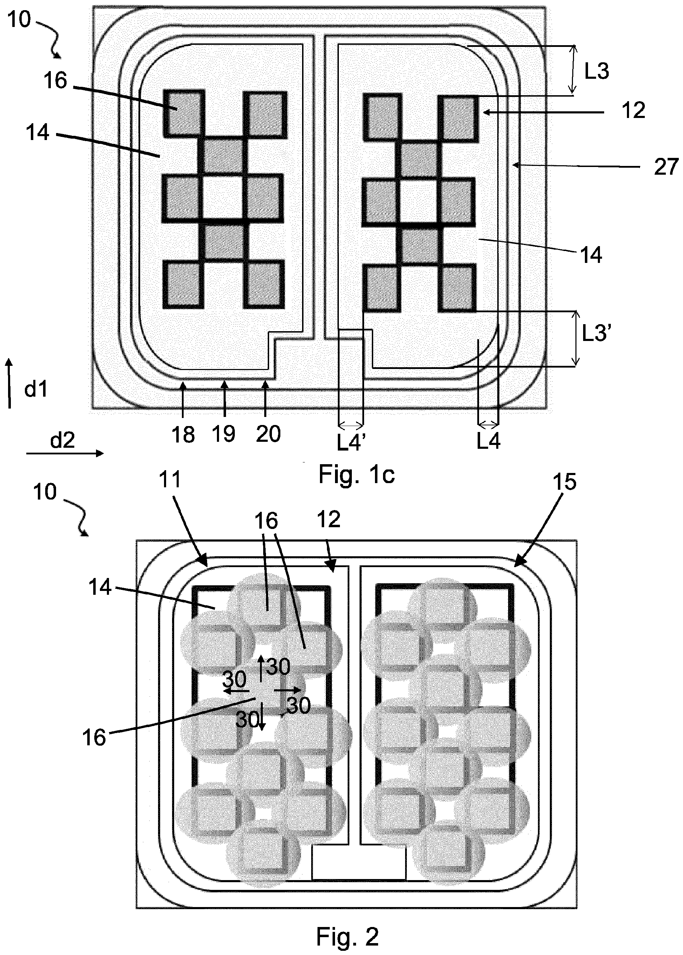

The regions 14 may have substantially the same size, e.g., the same area, as the regions 16, as shown in Fig. 1a. For instance, each region 14 may have a first area and each region 16 may have a second area, the first area and the second area extending in and/or parallel to the drawing plane of Figs. 1a to 1c. A ratio of the first area to the second area may be substantially 1:1, as shown in Fig. 1a. Alternatively, the regions 14 may have a different size, e.g., a different area, than the regions 16. For instance, as shown in Figs. 1b and 1c, the regions 14, or at least some of the regions 14, may have a different size, e.g., a different area, in particular with respect to an area which extends in or parallel to the drawing plane of Figs. 1a to 1c. Preferably, the regions 14, or at least some of the regions 14, may be larger, e.g., may have a larger area which extends in or parallel to the drawing plane of Figs. 1a to 1c, than the regions 16, or at least some of the regions 16. For instance, a ratio of the first area to the second area may be larger or smaller than 1:1. For instance, a ratio of the first area to the second area may be at least 1.1:1, preferably at least 1.5:1, more preferably at least 2:1, more preferably at least 2.5:1, more preferably at least 3:1. The first area may be an entire area of all regions 14 and/or the second area may an entire area of all regions 16. Providing insulated-gate bipolar transistor regions 14 which are larger than the diode regions 16 may improve IGBT conduction losses. This may provide advantages, in particular for motor drive applications. The region(s) 14 may surround, in particular in the perspective of Figs. 1b and 1c, the diode regions 16, in particular near the gate bus regions 27 (see the description further below).

The insulated-gate bipolar transistor regions 14 and/or the diode regions 16 may be arranged in a plurality of rows 18, 19, 20. Each row 18, 19, 20 may extend in a first direction d1. Along a second direction d2 which is substantially perpendicular to the first direction d1, the insulated-gate bipolar transistor regions 14 of at least two adjacent rows of the plurality of rows 18, 19, 20 and/or the diode regions 16 of at least two adjacent rows of the plurality of rows 18, 19, 20 are arranged in a staggered manner.

The transistor 10 may include a plurality of rows 21, 22, 23 of the insulated-gate bipolar transistor regions 14 and/or a plurality of rows 21, 22, 23 of the diode regions 16 along the second direction d2.

The insulated-gate bipolar transistor regions 14 and the diode regions 16 may be arranged in an alternating manner along the first direction d1 and/or the second direction d2.

The insulated-gate bipolar transistor regions 14 and the diode regions 16 may be separated from each other by at least one isolating region 28 configured to substantially isolate at least one of the insulated-gate bipolar transistor regions 14 from at least one of the diode regions 16.

Configuring the insulated-gate bipolar transistor regions 14 of at least two adjacent rows of the plurality of rows 18, 19, 20 and/or the diode regions 16 of at least two adjacent rows of the plurality of rows 18, 19, 20 in a staggered manner may increase and/or facilitate heat dissipation from the respective regions, e.g., by increasing a boundary area and/or boundary volume which borders the insulated-gate bipolar transistor regions 14 and/or the diode regions 16. This may improve a temperature distribution of the transistor 10, e.g., at one or more surfaces thereof.

Moreover, this may reduce a size of each insulated-gate bipolar transistor region 14 and/or each diode region 16, e.g., compared with a configuration in which the insulated-gate bipolar transistor regions 14 and/or the diode regions 16 are configured as lines or stripes, which may increase and/or facilitate heat dissipation from the respective region.

The transistor 10 may include at least one gate bus 27. The gate bus 27 may extend at least partially, preferably completely, around the transistor segment 11 and/or the transistor segment 15.

Each insulated-gate bipolar transistor region 14 and/or each diode region 16 may have an aspect ratio of a length L1 along the first direction d1 to a length L2 along the second direction d2 in a range of 0.4 to 2.5, preferably 0.5 to 2.4, more preferably 0.6 to 2.2, more preferably 0.6 to 2. As described above, the regions 14 may surround, in particular in the perspective of Figs. 1b and 1c, the diode regions 16, in particular near and/or adjacent to the gate bus regions 27, e.g., such that the region(s) 14 may be arranged at least partially between the respective gate bus region 27 and the region(s) 16. In this case, the region(s) 14 may extend in the direction d1 by a distance L3, L3', in particular from the adjacent region 16, in particular to the respective gate bus 27. The region(s) 14 may extend in the direction d2 by a distance L4, L4', in particular from the adjacent region 16, in particular to the respective gate bus 27.

Fig. 2 essentially shows, as an example. the transistor 10 of Fig. 1a, although the same features and/or effects described with respect to Fig. 2 may also generally apply to the transistor 10 of Figs. 1b and 1c. In particular, Fig. 2 shows the heat dissipation (indicated by arrows 30) from, e.g., the diode regions 16, e.g., during operation of the diode regions 16. The same may apply to the insulated-gate bipolar transistor regions 14, e.g., during operation of the insulated-gate bipolar transistor regions 14. In particular, the heat may be dissipated from the respective regions to adjacent or adjoining regions. For instance, as shown in Fig. 2, the diode regions 16 may dissipate heat to two or more, preferably three or more, adjacent insulated-gate bipolar transistor regions 14 and/or vice versa.

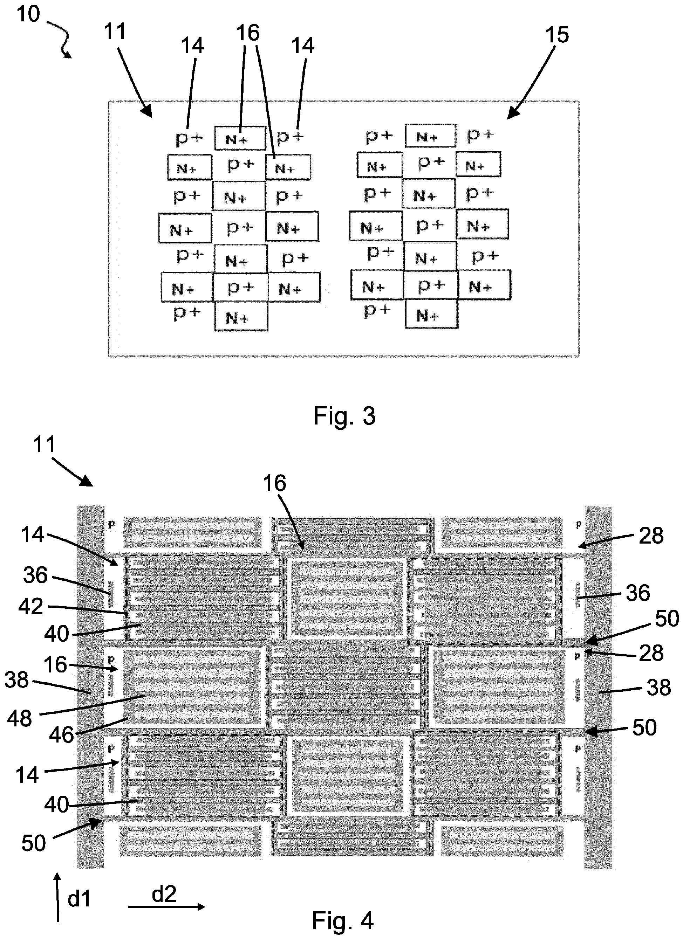

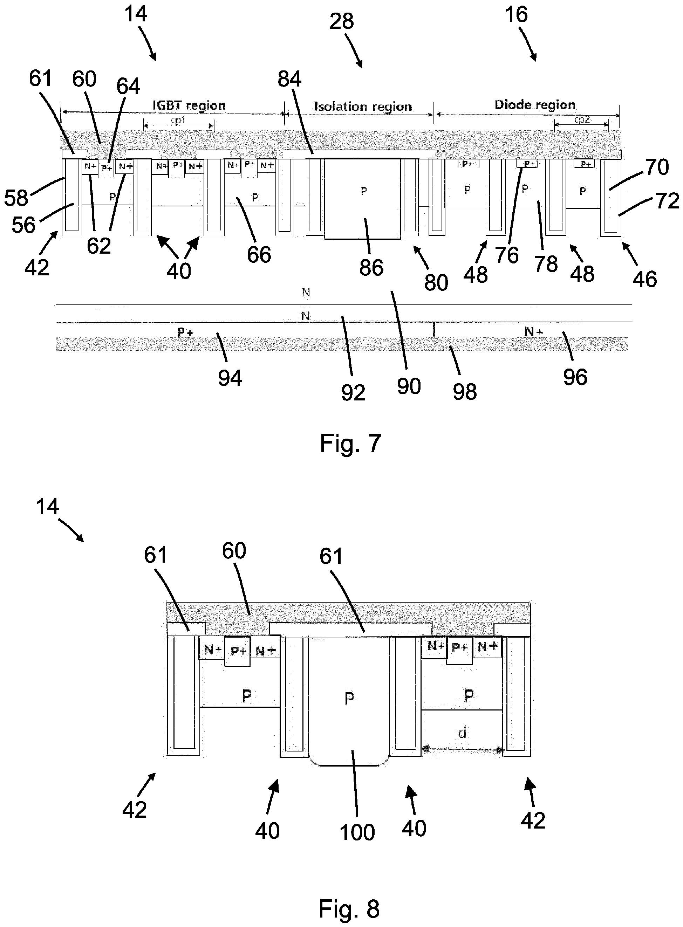

Fig. 3 shows a schematic bottom view of the transistor 10. In particular, the insulated-gate bipolar transistor regions 14 may each have a p type, in particular a p+ type region, at or towards the bottom of the respective insulated-gate bipolar transistor region 14, as shown in Fig. 3. The diode regions 16 may each have an n type, in particular an n+ type region, at or towards the bottom of the respective diode region 16, as shown in Fig. 3. One or more further layers, i.e., at least one back layer which may be made of metal, may be provided further towards the bottom of the transistor 10, i.e., which may at least partially cover the p+ type regions and n+ type regions shown in Fig. 3 (see, e.g., Fig. 7 and the corresponding description further below).

Fig. 4 shows an enlarged view of one of the transistor segments 11, 15, e.g., transistor segment 11, of the transistor 10. The transistor 10 may include one or more grounding contacts 36. The transistor 10 may include one or more gate bus bars 38. The gate bus bars 38 may be made of polysilicon.

Each insulated-gate bipolar transistor region 14 may include one or more trenches 40, 42, also referred to as gate trenches. Each insulated-gate bipolar transistor region 14 may include at least one first trench 42 which extends circumferentially around one or more second trenches 40 of the respective insulated-gate bipolar transistor region 14. Alternatively, or additionally, each diode region 16 may include a plurality of trenches 46, 48. Each diode region 16 may include at least one first trench 46 which extends circumferentially around one or more second trenches 48 of the respective diode region 16.

The transistor 10 may include at least one gate signal distributor trench 50 which interconnects one or more trenches 40, 42 of adjacent insulated-gate bipolar transistor regions 14.

At least a section of the gate signal distributor trench 50 may extend in the first direction d1 and/or the second direction d2. At least a section of the gate signal distributor trench 50 may extend along a substantially straight path, e.g., between the gate bus bars 38 (e.g., along direction d2 as shown in Fig. 4) and/or least a section of the gate signal distributor trench 50 may extend along a staggered path (e.g., along direction d1 as shown in Fig. 4), e.g., to avoid a cross junction to increase reliability.

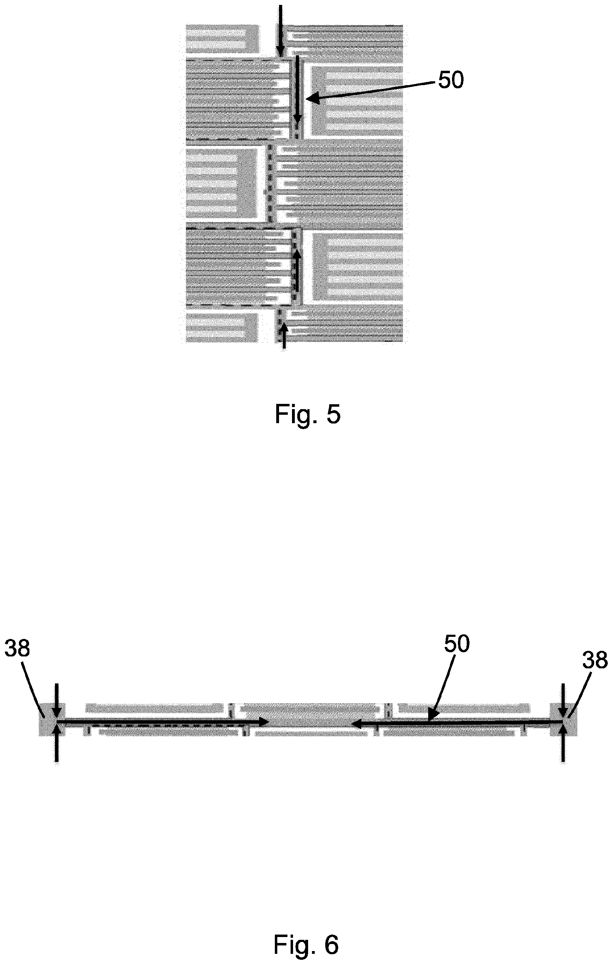

Fig. 5 shows, as an example, the above-mentioned staggered path of at least a section of the gate signal distributor trench 50, the path being indicated by arrows in Fig. 5.

Fig. 6 shows, as an example, the above-mentioned substantially straight path of at least a section of the gate signal distributor trench 50, the path being indicated by arrows in Fig. 6.

Fig. 7 shows, in a schematic and enlarged cross-sectional view, details of one of the insulated-gate bipolar transistor regions 14 and one of the diode regions 16 of the transistor 10. As discussed above, the insulated-gate bipolar transistor region 14 may include one or more trenches 40, 42, also referred to as gate trenches. The insulated-gate bipolar transistor region 14 may include at least one first trench 42 which extends circumferentially around one or more second trenches 40 of the respective insulated-gate bipolar transistor region 14. Each trench 40, 42 may be at least partially filled with at least one electrically conductive material 56, which may also be referred to as a gate electrode, which may be at least partially electrically insulated by at least one gate insulator film 58 which may at least partially cover or coat the conductive material 56. The trenches 40, 42 may be electrically connected or connectable, e.g., via one or more connecting elements or region 61, to a gate electrode terminal 60, e.g., an anode, which may be configured as at least one layer of metal. The trenches 40, 42 may be configured as active trenches.

The insulated-gate bipolar transistor region 14 may include one or more, preferably at least two, n+ type regions or implants 62. The insulated-gate bipolar transistor region 14 may at least one p+ type region or implant 64. The p+ type region or implant 64 may be arranged between at least two n+ type regions or implants 62. The p+ type region or implant 64 and/or n+ type region or implant 62 may be arranged between adjacent trenches 40, 42. The p+ type region or implant 64 and/or the n+ type regions or implants 62 may be implanted within a p type region 66.

As discussed above, the diode region 16 may include a plurality of trenches 46, 48. Each diode region 16 may include at least one first trench 46 which extends circumferentially around one or more second trenches 48 of the respective diode region 16. Each trench 46, 48 may be at least partially filled with at least one electrically conductive material 70 which may be at least partially electrically insulated by at least one insulator film 72 which may at least partially cover or coat the conductive material 70. One or more of the trenches 46, 48 may be configured as inactive or "dummy" trenches.

The diode region 16 may include at least one p+ type region or implant 76. The p+ type region or implant 76 may be implanted within a p type region 78.

The isolating region 28 may include at least one isolation trench 80. The isolation trench 80 may be electrically connected or connectable to the gate electrode terminal 60, e.g., via one or more connecting elements or regions 84. The isolating region 28 may include at least one deep diffused p type region 86.

The deep diffused p type region 86 may be arranged at least partially between at least two of the plurality of isolation trenches 80 and/or may be arranged at least partially within at least one isolation trench 80 which extends circumferentially around the deep diffused p type region 86.

A cell pitch or trench pitch cp1 of two adjacent trenches 40, 42 of the insulated-gate bipolar transistor region 14 may be different, in particular larger, than a cell pitch or trench pitch cp2 of two adjacent trenches 46, 48 of the diode region 16.

The transistor 10, in particular, the substrate 12, may include at least one intermediate layer 90, which may be configured as an n type region. Any of all of the trenches 40, 42, 46, 48, 80 may extend into the intermediate layer 90.

The transistor 10, in particular, the substrate 12, may include at least one buffer layer 92, which may be configured as an n type region.

The intermediate layer 90 and/or the buffer layer 92 may extend across the insulated-gate bipolar transistor region 14 and the diode region 16.

The insulated-gate bipolar transistor region 14 may include at least one p+ type region 94 which may be arranged on a side of the intermediate layer 90 and/or the buffer layer 92 which is opposite from the trenches 40, 42.

The diode region 16 may include at least one n+ type region 96 which may be arranged on a side of the intermediate layer 90 and/or the buffer layer 92 which is opposite from the trenches 46, 48.

The transistor 10 may include at least one cathode or collector layer 98, which may be made of metal.

Fig. 8 shows a modification of the insulated-gate bipolar transistor region 14. In particular, as shown in Fig. 8, the insulated-gate bipolar transistor region 14 may include at least one deep p type region 100. The deep p type region 100 may be arranged between trenches 40 and/or 42. The deep p type region 100 may be arranged between trenches 40. The trenches 40 may border the deep p type region 100. The deep p type region 100 may be configured as a dummy region.

A distance d between adjacent trenches, in particular the trench 40 and the trench 42, may d > 1 µm.

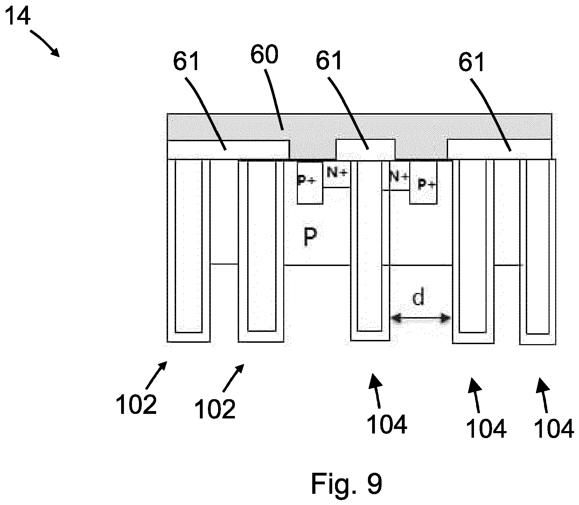

Fig. 9 shows a further modification of the insulated-gate bipolar transistor region 14. In particular, as shown in Fig. 9, the insulated-gate bipolar transistor region 14 may include least one first trench 102, preferably a plurality of first trenches 102. Each first trench 102 may be configured as a dummy gate. The insulated-gate bipolar transistor region 14 may include at least one second trench 104, preferably a plurality of second trenches 104. Each second trench 104 may be configured as a true gate. A distance d between adjacent trenches, in particular between adjacent second trenches 104, may d < 1 µm. The first trenches 102 and/or the second trenches 104 may electrically connected to the gate electrode terminal 60.

## Claims

1. A reverse conducting insulated-gate bipolar transistor (10), including:
a main substrate (12);
a plurality of insulated-gate bipolar transistor regions (14) provided on the main substrate (12);
a plurality of diode regions (16) provided on the main substrate (12);
wherein the insulated-gate bipolar transistor regions (14) and/or the diode regions (16) are arranged in a plurality of rows (18, 19, 20), each row (18, 19, 20) extending in a first direction (d1), and
wherein, along a second direction (d2) which is substantially perpendicular to the first direction (d1), the insulated-gate bipolar transistor regions (14) of at least two adjacent rows of the plurality of rows (18, 19, 20) and/or the diode regions (16) of at least two adjacent rows of the plurality of rows (18, 19, 20) are arranged in a staggered manner.

2. The transistor (10) according to claim 1, wherein the insulated-gate bipolar transistor regions (14) and the diode regions (16) are arranged in an alternating manner along the first direction (d1) and/or the second direction (d2).

3. The transistor (10) according to claim 1 or 2, wherein the transistor (10) includes a plurality of rows of the insulated-gate bipolar transistor regions (14) and/or a plurality of rows (21, 22, 23) of the diode regions (16) along the second direction (d2).

4. The transistor (10) according to any of the preceding claims, wherein the insulated-gate bipolar transistor regions (14) and the diode regions (16) are separated from each other by at least one isolating region (28) configured to substantially isolate at least one of the insulated-gate bipolar transistor regions (14) from at least one of the diode regions (16).

5. The transistor (10) according to claim 4, wherein each isolating region (28) includes at least one isolation trench (80), preferably a plurality of isolation trenches, and optionally at least one deep diffused p type region (86).

6. The transistor (10) according to claim 5, wherein the deep diffused p type region (86) is arranged at least partially between at least two of the plurality of isolation trenches (80) of the respective isolating region (28).

7. The transistor (10) according to any of the preceding claims, wherein each insulated-gate bipolar transistor region (14) and/or each diode region (16) has/have an aspect ratio of a length (L1) along the first direction (d1) to a length (L2) along the second direction (d2) in a range of 0.4 to 2.5, preferably 0.5 to 2.4, more preferably 0.6 to 2.2, more preferably 0.6 to 2.

8. The transistor (10) according to any of the preceding claims, further including at least one gate signal distributor trench (50) which interconnects one or more trenches (40, 42) of adjacent insulated-gate bipolar transistor regions (14).

9. The transistor (10) according to any of the preceding claims, wherein one or more of the insulated-gate bipolar transistor regions (14) include at least one first trench (42) which extends circumferentially around one or more second trenches (40) of the respective insulated-gate bipolar transistor region (14).

10. The transistor (10) according to any of the preceding claims, wherein each insulated-gate bipolar transistor region (14) includes at least one first trench (102), preferably a plurality of first trenches, each first trench being configured as a dummy gate, and at least one second trench (104), preferably a plurality of second trenches, each second trench being configured as a true gate.

11. The transistor (10) according to any of the preceding claims, wherein each insulated-gate bipolar transistor region (14) includes at least one deep p type region (100).

12. The transistor (10) according to any of the preceding claims, wherein each insulated-gate bipolar transistor region (14) includes a plurality of trenches (40, 42) and/or each diode region (16) includes a plurality of trenches (46, 48).

13. The transistor (10) according to claim 12, wherein at least two adjacent trenches of the plurality of trenches (40, 42) in one or more of the insulated-gate bipolar transistor regions (14) are arranged at a distance of at least 1 µm, preferably at least 2 µm, more preferably at least 3 µm, more preferably at least 4 µm, more preferably at least 5 µm.

14. The transistor (10) according to claim 12 or 13, wherein at least two adjacent trenches of the plurality of trenches (40, 42) in one or more of the insulated-gate bipolar transistor regions (14) are arranged at a distance of less than 1 µm, preferably less than 0.9 µm, more preferably less than 0.8 µm, more preferably less than 0.7 µm, more preferably less than 0.6 µm, more preferably less than 0.5 µm.

15. Method of manufacturing at least one reverse conducting insulated-gate bipolar transistor (10), preferably the reverse conducting insulated-gate bipolar transistor (10) according to any of the preceding claims, including:
- providing a main substrate (12);
- providing a plurality of insulated-gate bipolar transistor regions (14) and a plurality of diode regions (16) on the main substrate (12) such that the insulated-gate bipolar transistor regions (14) and/or the diode regions (16) are arranged in a plurality of rows (18, 19, 20), each row (18, 19, 20) extending in a first direction (d1), wherein, along a second direction (d2) which is substantially perpendicular to the first direction (d1), the insulated-gate bipolar transistor regions (14) of at least two adjacent rows of the plurality of rows (18, 19, 20) and/or the diode regions (16) of at least two adjacent rows of the plurality of rows (18, 19, 20) are arranged in a staggered manner.
